(19) **Europäisches Patentamt**
**European Patent Office**
**Office européen des brevets**

(11) Veröffentlichungsnummer : **0 091 711**
**B1**

(12) # EUROPÄISCHE PATENTSCHRIFT

(45) Veröffentlichungstag der Patentschrift :
**09.10.85**

(51) Int. Cl.⁴ : **H 03 F 1/08**, H 03 F 1/18,
**H 05 K 9/00**

(21) Anmeldenummer : **83200466.7**

(22) Anmeldetag : **31.03.83**

(54) Schmalbandverstärker, insbesondere Fernseh-Zwischenfrequenz-Verstärker.

(30) Priorität : **10.04.82 DE 3213406**

(43) Veröffentlichungstag der Anmeldung :
**19.10.83 Patentblatt 83/42**

(45) Bekanntmachung des Hinweises auf die Patenterteilung : **09.10.85 Patentblatt 85/41**

(84) Benannte Vertragsstaaten :
**BE CH DE GB IT LI**

(56) Entgegenhaltungen :
**DE-A- 1 591 076**
**DE-A- 1 938 647**
**DE-A- 2 264 112**
**DE-A- 2 607 195**
**US-A- 4 130 723**

(73) Patentinhaber : **Philips Patentverwaltung GmbH**
**Billstrasse 80**
**D-2000 Hamburg 28 (DE)**
**DE**
**N.V. Philips' Gloeilampenfabrieken**
**Groenewoudseweg 1**
**NL-5621 BA Eindhoven (NL)**
**BE CH GB IT LI**

(72) Erfinder : **Kupfer, Karl-Heinz**
**Krefelder Strasse 145**
**D-4150 Krefeld 29 (DE)**

(74) Vertreter : **Hartmann, Heinrich, Dipl.-Ing. et al**
**Philips Patentverwaltung GmbH Billstrasse 80 Postfach 10 51 49**
**D-2000 Hamburg 28 (DE)**

## Beschreibung

Die Erfindung betrifft einen Schmalbandverstärker nach dem Oberbegriff des Hauptanspruches.

Bei Verstärkerschaltungen, die auf einer Leiterplatte aufgebaut sind, ist es u. a. aus Platzgründen oft unvermeidbar, daß Eingangs- und Ausgangsleitungen des Verstärkers in unmittelbarer Nachbarschaft auf der Leiterplatte geführt sind. Dadurch kann ein Teil der Signalenergie vom Ausgang auf den Eingang rückgekoppelt werden, was zu Selbsterregung führen kann, wenn das Eingangssignal und das rückgekoppelte Ausgangssignal gleichphasig sind. Besonders ausgeprägt können derartige Effekte auftreten, wenn im Ausgang des Verstärkers ein Kreis mit Parallel-Resonanz angeordnet ist und die Eingangsleitung mit einer Ausgangsleitung gekoppelt ist, die vom Strom durch einen der Blindwiderstände durchflossen ist, und/oder wenn an den Eingangskreis ein auf die gleiche Frequenz abgestimmter Parallel-Resonanzkreis angeschlossen ist.

Aufgabe der vorliegenden Erfindung ist es, bei einem Verstärker der eingangs genannten Art die Auswirkungen der geschilderten Rückkopplung weitgehend zu beseitigen.

Diese Aufgabe wird erfindungsgemäß durch die im Kennzeichen des Hauptanspruches angegebenen Maßnahmen gelöst.

Es sei an dieser Stelle erwähnt, daß aus der US-PS 4 130 723 bereits eine der Verbindung mehrerer Digitalschaltungen dienende gedruckte Leiterplatte bekannt ist, die mit einer Vielzahl von Signalleitungen versehen ist und bei der zur Verminderung des Übersprechens zwischen benachbarten Signalleitungen geerdete Leiterbahnen geführt sind.

Bei der Erfindung wird die Rückkopplung dadurch verringert, daß die Gleichspannungs-Versorgungsleitung gleichzeitig einen Teil eines auf eine Frequenz in der Nähe der Signalfrequenz abgestimmten Parallel-Resonanzkreis bildet, der einen Teil der Energie aus der Ausgangsleitung absorbiert und im folgenden als Absorptionskreis bezeichnet wird. Von den dafür erforderlichen beiden Kondensatoren muß der eine Kondensator, der Wechselspannungen mit der Signalfrequenz kurzschließt, in der Regel ohnehin vorhanden sein, so daß für die erfindungsgemäße Maßnahme lediglich nur noch ein Kondensator erforderlich wird.

Die Frequenz, auf der der Absorptionskreis in Parallelresonanz ist, hängt von der Länge des Leitungsabschnittes zwischen den beiden Kondensatoren und von der Kapazität des anderen (kleineren) Kondensators ab ; sie ist um so größer, je kürzer der Abschnitt und je kleiner diese Kapazität ist. Die Resonanzfrequenz darf nicht zu weit von der Signalfrequenz entfernt sein, da sonst nur noch sehr wenig Energie in die Versorgungsleitung eingekoppelt wird, so daß die Kopplung zwischen Ausgangs- und Eingangsleitung dadurch kaum noch verringert werden könnte. Auf der anderen Seite dürfen die Flanken des Übertragungsbereiches des Schmalbandverstärkers durch den Absorptionskreis nicht frequenzabhängig verformt werden.

Die Wirksamkeit des Absorptionskreises hängt außer von seiner Resonanzfrequenz von seiner Kopplung mit den einander benachbarten Leitungsabschnitten von Ausgangs- und Eingangsleitung sowie von seiner Dämpfung ab. Er ist um so wirksamer, je stärker die Kopplung und je größer seine Dämpfung ist. Die Kopplung wird vom Abstand der Leitungen von der Versorgungsleitung bestimmt sowie davon, ob die einander eng benachbarten Abschnitte von Eingangs- und Ausgangsleitung näher an dem (über den größeren Kondensator) mit Masse verbundenen Ende oder näher am anderen Ende liegen. Die Dämpfung des Absorptionskreises wird von den Verlusten der Versorgungsleitung bestimmt — die mit der Wahl des Materials der Leiterplatte und der Leiterbahnen aber praktisch vorgegeben sind — und von den Verlusten der Kondensatoren. Sie hängt außerdem von der Länge der Leitung und der Kapazität der Kondensatoren ab.

Die Erfindung wird nachstehend anhand der Zeichnung näher erläutert. Es zeigen

Figur 1 einen Teil eines Schaltbildes eines Kanalwählers mit einem erfindungsgemäßen Schmalbandverstärker und

Figur 2 die Durchlaßkurve dieses Schmalbandverstärkers.

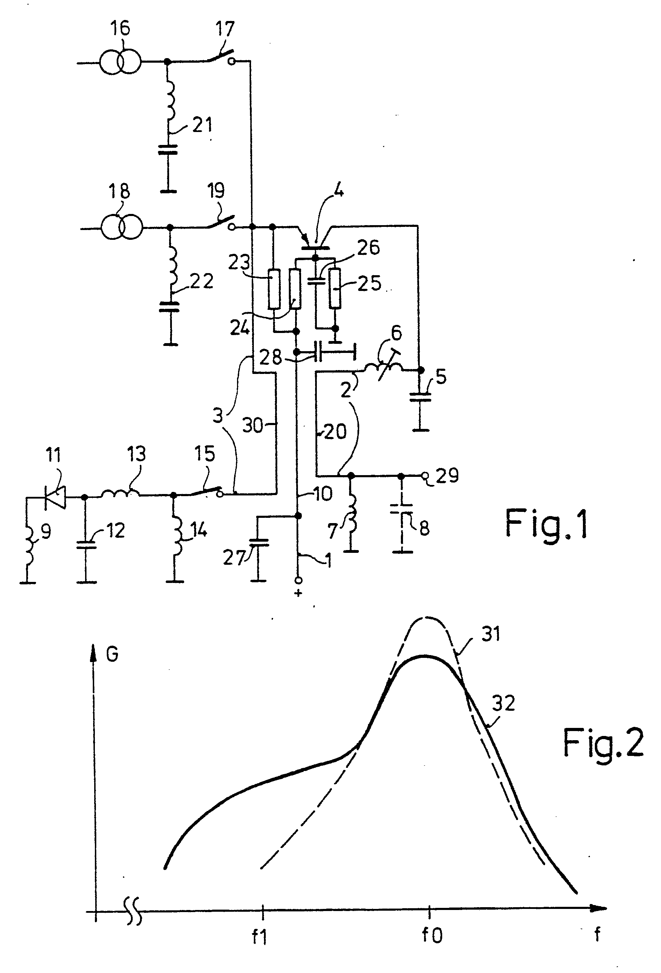

Fig. 1 zeigt den Ausgang eines UHF/VHF-Kanalwählers. Der das Ausgangssignal liefernde in Basisschaltung betriebene pnp-Transistor 4 vom Typ BF324 arbeitet für UHF als Zwischenfrequenzverstärker und für VHF als Mischtransistor, wobei das VHF-Signal in der Mischstufe mit einem Oszillatorsignal gemischt wird. Der Kollektor des Transistors 4 ist mit einem auf die Zwischenfrequenz abgestimmten Parallel-Resonanzkreis verbunden. Der Parallel-Resonanzkreis enthält einen Kondensator 5, dessen einer Anschluß mit dem Kollektor des Transistors 4 und dessen anderer Anschluß mit Masse verbunden ist, und eine Spule 6, deren einer Anschluß mit dem Kollektor des Transistors 4 verbunden ist und deren anderer Anschluß über eine Leitung 2 und eine Spule 7 mit Masse verbunden ist. Der nicht mit Masse verbundene Anschluß der Spule 7 bildet den Ausgang des Verstärkers, an den über ein geeignetes Filter ein Zwischenfrequenzverstärker angeschlossen wird. Dadurch liegt, wie durch gestrichelte Linien angedeutet, eine relativ große Kapazität 8 parallel zur Spule 7, so daß die Resonanzfrequenz des Parallel-Resonanzkreises — die Zwischenfrequenz — praktisch ausschließlich durch die Werte der Elemente 5 und 6 bestimmt ist ; die Spule 7 hat lediglich den Zweck, den Kollektor des Transistors 4 gleichstrommäßig mit Masse zu verbinden.

Die UHF-Signale werden der Schaltung über eine Spule 9 zugeführt, deren einer Anschluß mit Masse und deren anderer Anschluß mit einer UHF-Mischdiode 11 verbunden ist, in der das UHF-Signal mit einem auf nicht näher dargestellte Weise erzeugten Oszillatorsignal gemischt wird. Das andere Ende der Mischdiode 11 ist über einen Kondensator 12 mit Masse verbunden. Der Verbindungspunkt des Kondensators 12 und der Mischdiode 11 ist über eine Spule 13 mit einer Spule 14 verbunden, deren anderer Anschluß ebenfalls mit Masse verbunden ist. Der Kondensator 12 und die Serienschaltung der beiden zu ihm parallel liegenden Spulen 13 und 14 bilden einen Parallel-Resonanzkreis, der auf die Zwischenfrequenz abgestimmt ist und der Mischprodukte mit einer von der Zwischenfrequenz abweichenden Frequenz unterdrückt. Das Verhältnis der Induktivitäten der Spulen 13 und 14 ist so gewählt, daß der Resonanzkreis an den Eingang der Verstärkerstufe angepaßt ist, und dementsprechend ist der Verbindungspunkt der Spulen 13 und 14 über einen elektronischen Schalter 15 und eine Leitung 3 mit der Basis des Transistors 4 verbunden.

Beim Empfang von VHF-Signalen gelangen diese über das Bandfilter 16 und den Schalter 17 an die Basis des Transistors 4, während beim Empfang von Signalen aus dem VHF-Bereich III die Signale über das Filter 18 und den Schalter 19 an die Basis des Transistors gelangen. Die Ausgänge der Filter 16 bzw. 18 sind über zwei auf die Zwischenfrequenz abgestimmte Serien-Resonanzkreise 21 bzw. 22 mit Masse verbunden.

Die (positive) Versorgungsspannung wird dem Transistor 4 über eine Leitung 1 zugeführt, die über einen Widerstand 23 mit dem Emitter und über einen Widerstand 24 mit der Basis verbunden ist, die ihrerseits über einen Widerstand 25 mit Masse verbunden ist, dem ein Siebkondensator 26 parallelgeschaltet ist.

Die Ausgangsleitung 2 und die Eingangsleitung 3 haben Abschnitte 20 bzw. 30, die auf der nicht näher dargestellten Leiterplatte sehr eng — z. B. in einem Abstand von 1,5 mm — nebeneinander hergeführt sind und eine gewisse Länge, z. B. 20 mm, haben. Dadurch ergibt sich eine Mitkopplung vom Ausgang auf den Eingang. Beim Empfang von Signalen aus einem der VHF-Bereiche I oder III wirkt sich diese Mitkopplung praktisch nicht aus, weil der Eingang des dann als Mischstufe arbeitenden Verstärkers 4 durch einen der Serien-Resonanzkreise 21 oder 22 für die Zwischenfrequenz kurzgeschlossen ist. Beim UHF-Betrieb jedoch, bei dem die Schalter 17 und 19 geöffnet und der Schalter 15 geschlossen ist und der transistor 4 als Zwischenfrequenzverstärker wirksam ist, ist an den Emitter des Transistors der Parallel-Resonanzkreis 12, 13, 14 über den Schalter 15 angeschlossen, so daß die rückgekoppelten Zwischenfrequenzsignale am Emitter des Transistors 4 wirksam werden können. Als Folge dieser positiven Rückkopplung (Mitkopplung) wird die Bandbreite des Schmalbandverstärkers verringert bzw. er wird instabil, wenn die Steilheit des Transistors 4 genügend groß ist.

Um diesen Rückkopplungseffekt zu unterbinden, ist die Versorgungsleitung 1 zwischen den beiden Abschnitten 20 und 30 hindurchgeführt, was schon eine gewisse Entkopplung mit sich bringt. An die Versorgungsleitung ist in der Nähe des Randes der Leiterplatte ein Kondensator 27 mit einer Kapazität von 10 nF angeschlossen, der für die Zwischenfrequenz praktisch einen Kurzschluß darstellt. Ein weiterer Kondensator 28 verbindet einen Punkt auf der Versorgungsleitung 1 in der Nähe der zur Vorspannungserzeugung erforderlichen Widerstände 23... 25 mit Masse. Zwischen den Anschlußpunkten der beiden Kondensatoren 27 und 28 ergibt sich somit ein Leitungsabschnitt 10, der zwischen den einander eng benachbarten Ab-Abschnitten 20 und 30 auf der Ausgangs- bzw. Eingangsleitung liegt. Dieser Abschnitt hat eine bestimmte Induktivität, der der Kondensator 28 parallelgeschaltet ist und die mit diesem zusammen einen Parallel-Resonanzkreis bildet, der bei etwa 30 MHz in Resonanz ist und einen Teil der Rückkopplungsenergie absorbiert.

Am wirksamsten wäre ein solcher Absorptionskreis, wenn er genau auf die Zwischenfrequenz abgestimmt wäre. Da jedoch an die Ausgangsklemme 29 des Verstärkers noch die weiteren Teile eines mehrkreisigen Bandfilters angeschlossen werden müssen, die unterschiedlich abgeglichen sein können, könnte es vorkommen, daß der Absorptionskreis auf eine Frequenz abgestimmt ist, die so weit von der Zwischenfrequenz abweicht, daß die Zwischenfrequenz-Durchlaßkurve erhebliche Unsymmetrien aufweisen würde. Deshalb ist für den Absorptionskreis eine unterhalb der Zwischenfrequenz liegende Resonanzfrequenz gewählt worden.

Grundsätzlich könnte die Resonanzfrequenz des Absorptionskreises zwar auch oberhalb der Zwischenfrequenz liegen, doch würde sie dann zumindest in der Nähe der unteren Kanäle des VHF-Bereiches I liegen, was dort wiederum Schwierigkeiten hervorrufen könnte.

Die Abstimmung des Absorptionskreises auf die Frequenz von 30 MHz erfolgt durch geeignete Bemessung der Länge des Abschnittes 10 — er ist etwa 5 cm lang — und der Kapazität des Kondensators 28.

Die Kopplung zwischen den beiden Abschnitten 20 und 30 hängt nicht nur von der Resonanzfrequenz des Absorptionskreises ab, sondern auch von dessen Dämpfung und von seiner Kopplung mit dem Leitungsabschnitt 20.

Die Kopplung kann auf verschiedene Weise beeinflußt werden, z. B. durch den Abstand zwischen den Abschnitten 10 und 20. Die Kopplung hängt aber auch von der Lage des Leitungsabschnittes in bezug auf die benachbarten Abschnitte 20 und 30 ab: Je näher die beiden letztgenannten Abschnitte am sogenannten « heißen » Ende des Absorptionskreises liegen, das durch den Anschlußpunkt des Kondensators 28 an der Leitung 1 gegeben ist, desto stärker ist die Kopplung.

Auch die Länge des Abschnittes 10 hat einen Einfluß auf die Kopplung ; es versteht sich, daß die Kapazität des Kondensators 28 dann so variiert werden muß, daß sich wieder die gleiche Resonanfrequenz ergibt. Die Länge der Leitung 10 hat auch einen Einfluß auf die Dämpfung bzw. die Bandbreite des Absorptionskreises, die schließlich auch noch durch die Verluste des Kondensators 28 bestimmt wird. Bei einer praktischen erprobten Schaltung wurde ein Keramik-Kondensator vom Typ X7R benutzt, der relativ große Verluste aufweist (Verlustfaktor ca. 0,02).

Fig. 2 zeigt den Übertragungsfaktor des in Fig. 1 dargestellten Zwischenfrequenzverstärkers als Funktion der Frequenz. Die gestrichelte Kurve 31 stellt dabei den Frequenzgang ohne den Absorptionskreis dar, während die in ausgezogenen Linien dargestellte Kurve 32 den Frequenzgang mit dem Absorptionskreis darstellt. Ohne den Absorptionskreis ergibt sich bei der Zwischenfrequenz f0 (36,8 MHz) eine ausgeprägte Resonanz, wobei die 3 dB-Bandbreite kleiner ist als 2 MHz. Durch den Absorptionskreis wird der Übertragungsfaktor bei der Resonanzfrequenz verringert, so daß sich eine Bandbreite von etwa 2 MHz ergibt. (Die Kurve 32 stellt den Verlauf des Übertragungsfaktors dar, wenn an den Transistor 4 lediglich der aus Fig. 1 ersichtliche Resonanzkreis angeschlossen wird. Wird dieser Kreis hingegen, wie angegeben, zu einem mehrkreisigen Bandfilter ergänzt, ergibt sich die Für Fernsehsignale erforderliche 3 dB-Bandbreite von 5,5 MHz.)

Deutlich ist zu erkennen, daß die Filterkurve 32 bei Frequenzen unterhalb des 2 MHz-Durchlaßbandes weniger steil verläuft als die Kurve 31 (ohne Absorptionskreis). Kopplung und Dämpfung des Absorptionskreises sind so gewählt, daß der Übertragungsfaktor bei der Resonanzfrequenz des Absorptionskreises (30 MHz) um rund 10 dB niedriger liegt als bei der Zwischenfrequenz f0.

Mit Hilfe des Absorptionskreises konnte die durch Fertigungsstreuungen bedingte Bandbreitenänderung innerhalb zulässiger Grenzen gehalten und eine Selbsterregung des Zwischenfrequenzverstärkers bei UHF-Betrieb vollständig ausgeschlossen werden.

## Patentansprüche

1. Schmalbandverstärker, dessen Eingangsleitung auf einer Leiterplatte zumindest abschnittsweise in enger Nachbarschaft zu einer Leitung im Ausgang des Verstärkers angeordnet sind, dadurch gekennzeichnet, daß zwischen den beiden Leitungen (2, 3) eine Leitung (1) zur Gleichstromversorgung des Verstärkers geführt ist, an die zwei Kondensatoren (27, 28) angeschlossen sind, von denen der eine (27) für die Signalfrequenz im wesentlichen einen Kurzschluß darstellt und der andere (28) so bemessen ist, daß er zusammen mit dem zwischen den beiden Kondensatoren liegenden Leitungsabschnitt (10) einen Parallel-Resonanzkreis bildet, der in der Nähe der Signalfrequenz des Verstärkers in Resonanz ist, und daß dieser Abschnitt (10) im Bereich der einander eng benachbarten Abschnitte (20, 30) der Ein- und Ausgangsleitung des Verstärkers liegt.

2. Als Fernseh-Zwischenfrequenz-Verstärker ausgebildeter Schmalbandverstärker nach Anspruch 1, dadurch gekennzeichnet, daß die Resonanzfrequenz (f1) unterhalb der Zwischenfrequenz (f0) liegt.

3. Zwischenfrequenz-Verstärker nach Anspruch 2, dadurch gekennzeichnet, daß die Resonanzfrequenz bei 30 MHz liegt.

## Claims

1. A narrow-band amplifier the input line of which is provided, at least partly, on a printed circuit board very close to a line at the output of the amplifier, characterized in that a direct current supply line (1) of the amplifier is arranged between the two lines (2, 3), two capacitors (27, 28) being connected to the said line, one of the capacitors (27) forming substantially a short-circuit for the signal frequency and the other (28) being dimensioned such that together with the line section (10) between the two capacitors it provides a parallel-resonant circuit which resonates in the region of the signal frequency of the amplifier, and that this line section (10) is located in the region of the closely adjacent sections (20, 30) of the input and output lines of the amplifier.

2. A narrow-band amplifier as claimed in Claim 1, in the form of a television intermediate-frequency amplifier, characterized in that the resonant frequency (f1) is located below the intermediate frequency (f0).

3. An intermediate-frequency amplifier as claimed in Claim 2, characterized in that the resonant frequency is located at 30 MHz.

## Revendications

1. Amplificateur à bande étroite, dont le conducteur d'entrée est situé sur une plaque de circuits imprimés, au moins sur une partie de son trajet, tout près du conducteur de sortie de l'amplificateur, caractérisé en ce qu'entre ces deux conducteurs (2, 3) est prévu un conducteur (1) pour l'alimentation en courant continu de l'amplificateur, auquel sont raccordés deux condensateurs (27, 28), dont l'un (27) constitue pratiquement un court-circuit pour la fréquence de signal et l'autre (28) est dimensionné de façon à constituer, de concert avec le tronçon de conducteur (10) compris entre les deux condensateurs, un circuit de résonance parallèle, qui est en résonance au voisinage de la fréquence de signal de l'amplificateur, et en ce que ce tronçon (10) se situe près des tronçons adjacents des conducteurs d'entrée et de sortie (20, 30) de l'amplificateur.

2. Amplificateur à bande étroite sous forme d'un amplificateur de fréquence intermédiaire selon la revendication 1, caractérisé en ce que la fréquence de résonance (f1) se situe au-dessous de la fréquence intermédiaire (f0).

3. Amplificateur à fréquence intermédiaire selon la revendication 2, caractérisé en ce que la fréquence de résonance se situe à 30 MHz.

Fig.1

Fig.2